(19) Europäisches Patentamt
European Patent Office
Office européen des brevets

(11) Publication number: **0 461 491 A1**

(12) **EUROPEAN PATENT APPLICATION**

(21) Application number: **91108925.8**

(51) Int. Cl.5: **G03F 7/022**

(22) Date of filing: **31.05.91**

(30) Priority: **08.06.90 IT 2058790**

(43) Date of publication of application:
**18.12.91 Bulletin 91/51**

(84) Designated Contracting States:
**AT BE CH DE DK ES FR GB GR IT LI LU NL SE**

(71) Applicant: **PLURIMETAL S.R.L.**
**Via Salieri, 4**
**I-37050 Vallese di Oppeano (Verona)(IT)**

(72) Inventor: **Rinaldi, Rinaldo**
**Via Salieri, 4**
**I-37050 Vallese di Oppeano, (Verona)(IT)**

(74) Representative: **Minoja, Fabrizio**
**Studio Consulenza Brevettuale Via Rossini, 8**
**I-20122 Milano(IT)**

(54) **Photosensitive mixtures.**

(57) Photosensitive mixtures containing combinations of naphthoquinone-diazide-5-sulfonic acid esters with phenol-formaldehyde resins, 1-50% basic dyes and not more than 4.5% of hexaflurophosphate 2,5-diethoxy-4-(para-tolyl-mercapto)benzene-diazonium allow to obtain an optimum combination of the following characteristics:

- oolor change of the image after exposure to UV, even at the yellow light;
- contrast;
- fog;
- correction.

EP 0 461 491 A1

The present invention relates to photosensitive mixtures, which are remarkably improved in comparison with those of the prior art and consist of mixtures of naphthoquinone-(1,2)-diazide-5-sulfonic acid esterified with phenol-formaldehyde resins, basic dyes and a photosensitive diazonium salt capable to release acids when exposed to light.

The use of naphthoquinonediazide derivatives for the preparation of photosensitive mixtures has been known for various decades : see, for instance, German Patents 854,890 and 938,233. Some of the drawbacks evidenced in these first uses, above all the inadequacy of the color change of the image, have been overcome only partially by means of subsequent improvements, such as those claimed in USA-P-3,669,658 (characterized by the presence of a leuko dye) and in German Patent 1,447,011, in which an indicator dye with a color change range at pH 2.5-6.5 is added. Other variations of azo-compounds (consisting in the use of novolac resins) or of a naphthoquinonediazide-4-sulfonic acid halide are disclosed in German Patents 2,229,365 and 2,331,377.

However, none of the mixtures disclosed in the above cited patent literature could achieve definitely satisfying results, said mixtures proving to depend markedly on chemico-physical treatments carried out on the aluminium support.

Finally, German Patent 2,641,099 discloses a photosensitive mixture containing a combination of a naphthoquinone-diazide-sulfonic or -carboxylic acid ester or amide; a triphenylmethane, azine or anthraquinone dye, in an amount of 1-50% by weight; and a photosensitive halogenated diazonium salt (capable to release acidity when exposed to light) in an amount of 5-75% by weight. Particularly, said patent claims compositions containing 10 to 40% by weight photosensitive diazo-compound; this range corresponding to the data reported in the Examples, relating to compositions containing 10, 16, 19, 27, 30, 35 and 40% of photosensitive diazo-compound, respectively. Triphenylmethane dyes are preferred; the naphthoquinonediazide derivatives more frequently used being naphthoquinone-(1,2)-diazide-(2)-5-sulfonic acid esters with 2,3,4-trihydroxybenzophenone and with 2,2'-dihydroxydinaphthyl-(1,1')-methane. The compositions claimed in said patent are certainly better than those of the prior art as far as the color change of the image after exposure is concerned, but they proved to be definitely unsatisfactory with regard to two other main characteristics of the obtained plates, i.e. fog and correction.

The used terminology is explained hereinbelow:

- color change: after exposing the plate, on which a film (positive or negative) has been placed, to a UV lamp, the exposed areas take a different color than those which received no light, being protected by the film. Thus the image is evidenced before development of the plate, this resulting very useful in routine works or with photo-composing machines;
- contrast: it is the difference in optical density between the plate background (i.e. the area free from the emulsion after development) and the image area (i.e. the one in which the emulsion remains after development);
- fog: it consists in the emulsion traces remaining homogeneously fixed to the background even after development. The presence of said trace involves a decrease in contrast and a scumming also in areas outside the image;
- correction: it consists in the operation by which, after development of the plate, the image areas can be removed by means of chemicals, generally in form of gels and often containing hydrofluoric acid, to carry out small retouchings. The chemical action of correctors generally is strong enough to remove, besides the emulsion, also any fog, in this case evidencing the white background of the aluminium support, therefore contrasting with uncorrected areas, in which fog is still present.

Now it has surprisingly been found that photosensitive mixtures having an optimum combination of the three characteristics mentioned above are obtained by means of a combination of:

a) a naphthoquinone-(1,2)-diazide-5-sulfonic acid ester with a resin of the phenol-formaldehyde class;

b) 1 to 50% by weight of one or more basic dyes;

c) a photosensitive diazonium salt, which is capable to release acids when exposed to light, in an amount from 1 to 4.5% by weight, preferably from 1.5 to 2.2% by weight.

Component a) of the composition disclosed above is an ester of the mentioned acid with a phenol-formaldehyde resin or with a cresol-formaldehyde resin, generally containing 1.3-1.6% by weight nitrogen, on the structural formula of which depend other chemical and physical characteristics of the plate.

Triphenylmethane substituted derivatives, in which the phenyl groups are replaced by $NH_2$, OH, $HSO_3$ or other groups; azine dyes, such as phenazines or oxyazines; anthraquinone dyes with chromophore groups formed by $>C=O$ or $>C=C<$ can be used as the basic dyes.

The photosensitive diazonium salt has general formula (I)

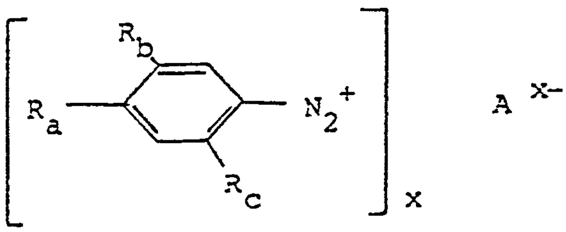

(I)

wherein:

$R_a$ is hydrogen, halogen, or an optionally substituted alkyl, alcoxy, aryloxy, arylamino, arylmercapto, benzoylamino group;

$R_b$ and/or $R_c$ are hydrogen or optionally substituted alkyl, alkylmercapto, alcoxy group, in which the alkyl residue is $C_1$-$C_3$, or aryloxy or arylmercapto groups;

A is $PF_6$, $BF_4$, $AsF_6$, $SbCl_6$, $SnCl_6$, $BiCl_5$, $ZnCl_4$, $SbF_6$, x being 1 or 2;

$R_a$ and $R_b$ cannot be hydrogen atoms at the same time.

The salt of general formula (I) splits photolytically releasing the acid, then it reacts with the dye causing the color change.

The above described compounds have a lower activity, as acid donors, than other compounds which are typically used for the same purpose, among which, for example, are substituted symmetrical triazines; this involves that the same effect can be achieved using percentages of the diazonium salt which are even three times those of triazines: this is possible, inter alia, since the light amount which is adsorbed by product cleavage is comparable, however such a disadvantage is made up by the better availability of the diazonium salt (for example 15 $PF_6$ by Rohner AG, Swiss), by the lower cost than that of triazines and generally by a better solubility in the solvents conventionally used in the preparation of photosensitive emulsions.

Very good results have also been achieved as far as the shelf-life of the obtained preparations as well as the resistance to long runs are concerned.

The compositions of the invention preferably contain no more than 2-2.5% of photosensitive diazo-compound. It is surprising that with such low percentages of diazo-compound, generally of about 1/10$^{th}$ those used according to the prior art, definitely very good results can be obtain as regard color change after exposure, fog, correction, keeping a good contrast level before and after the plate development.

The compositions of the invention can also contain traditional additives, such as Bakelite resins, maleimide resins, surfactants and the like.

The invention is further illustrated by the following examples, some of which (particularly example 1 and above all example 4) are comparative examples. Percentages are by weight.

EXAMPLE 1

The photosensitive emulsion contains:

| | |
|---|---|
| 2,1-naphthoquinone-diazide-5-sulfonic acid ester with a cresol-formaldehyde resin, containing 1.6% $N_2$ | 48% |
| 2,1-naphthoquinone-diazide-5-sulfonic acid ester with a cresol-formaldehyde resin, containing 1.4% $N_2$ | 48% |
| "Diazo 15 $PF_6$" | 3% |
| Crystal violet (C.I.42555) | 1.2% |

The above described formulation is dissolved in a solvent mixture of the following composition (by

weight):
80% ethylene gycol monobutyl ether
20% dimethylformamide
to obtain a solution containing 34% by weight solid. The resulting solution is spread on a grained anodized aluminiun plate to obtain, upon baking in oven, a 2.0 g/m² coating.

The color of the resulting plate is green-blue. After exposure to U.V. light, the irradiated areas of the plate have a more intense blue color, while the image formed by the negative film can be observed at both white and yellow lights, remaining of the original color.

Therefore the plate can be developed by means of a traditional aqueous developer with alkaline reaction. The resulting image can be clearly seen and it has a good contrast from the background.

EXAMPLE 2

The coating composition contains:

| | |
|---|---|
| 2,1-naphthoquinone-diazide-5-sulfonic acid ester with a phenol-formaldehyde resin, containing 1.6% $N_2$ | 65% |
| 2,1-naphthoquinone-diazide-5-sulfonic acid ester with a phenol-formaldehyde resin, containing 1.4% $N_2$ | 32% |
| "Diazo 15 $PF_6$" | 1.7% |
| Crystal violet (C.I. 42555) | 1% |

The formulation is dissolved in the same solvent mixture as in Example 1, to obtain a solution containing 34% by weight solid. The resulting emulsion is spread on a grained anodized aluminium plate to obtain, after evaporation of the solvent, a coating of about 2 g/m².

EXAMPLE 3

The positive emulsion contains:

| | |
|---|---|
| 2,1-naphthoquinone-diazide-5-sulfonic acid ester with a phenol-formaldehyde resin, containing 1.6% $N_2$ | 48% |
| 2,1-naphthoquinone-diazide-5-sulfonic acid ester with a phenol-formaldehyde resin, containing 1.4% $N_2$ | 34% |
| Bakelite resin 744 | 1.75% |
| "Diazo 15 $PF_6$" | 1.75% |
| Crystal violet | 0.30% |
| Victoria blue B (Basic Blue 26) | 1% |

The formulation is dissolved in the same solvent mixture as in Example 1, to obtain a 34% solid

content. The resulting emulsion is spread on a grained anodized aluminium plate to obtain, after baking, a coating of about 2 g/m$^2$.

EXAMPLE 4

The emulsion contains:

| | |
|---|---|
| 2,1-naphthoquinone-diazide-5-sulfonic acid ester with a phenol-formaldehyde resin, containing 1.6% $N_2$ | 47% |
| 2,1-naphthoquinone-diazide-5-sulfonic acid ester with a phenol-formaldehyde resin, containing 1.4% $N_2$ | 33% |
| Bakelite resin 744 | 14% |
| "Diazo 15 $PF_6$" | 5% |
| Crystal violet | 0.3% |
| Victoria blue B | 1% |

The formulation is dissolved in the same solvent mixture as in the above Examples, to obtain a 34% solid content. The resulting emulsion is spread on a grained anodized aluminium plate to obtain, after baking, a coating of about 2 g/m$^2$.

EXAMPLE 5

The negative emulsion contains:

| | |
|---|---|
| Condensation product between 4-diazo-diphenylamine sulfate and formaldehyde, isolated as 2-hydroxy-4-methoxy-benzophenone-5-sulfonate | 0.50% |
| "Diazo 15 $PF_6$" | 1.90% |
| Tenside (polysyloxane-polyether copolymer) | 1.51% |
| Dimethylmaleimide resin (copolymer with metacrylic acid) | 88.4% |
| Thioxanthone (n-octyl-2-ethylhexyl)ester | 7.1% |
| Crystal violet | 0.70% |

The formulation is dissolved in a solvent mixture containing:
dimethylformamide 23%
methoxypropanol 77%.

The resulting emulsion is spread on a grained anodized aluminium plate to obtain, after baking, a coating of about 2 g/m$^2$. After exposure to an U.V. lamp, a very good contrast between the exposed areas and the non-exposed ones can be clearly seen, both at the white and yellow lights.

The comparative results of the above examples are summarized hereinbelow, in order to evaluate the

best formulations:

| Example | 1 | 2 | 3 | 4 | 5 |
|---|---|---|---|---|---|
| Contrast | very good | good | good | very good | good |
| Fog | intense | slight | slight | excessive | slight |
| Correction | visible | invisible | invisible | very bad | invisible |

The above data show that the use of product percentages higher than 2.5% improves the image contrast but also the fog on the background, thus markedly evidencing the correction and therefore causing a hazard of bad performance during the printing, such as, for example, a tendency to scumming effect.

The best compromise for an effective use of the product is obtained within a concentration range of the photosensitive diazo-compound between 1.5 and 2.2, expressed as % on total solid content.

## Claims

1. A photosensitive mixture containing a combination of:
   - one or more of 2,1-naphthoquinone-diazide-5-sulfonic acid esters with a phenol-formaldehyde resin;
   - 1-50% by weight of one or more basic dyes;
   - 1-4.5% by weight of a photosensitive diazonium salt capable to release acids when exposed to light.

2. The mixture according to claim 1, characterized in that the photosensitive diazonium salt is present in the combination in a proportion ranging from 1.5 to 2.2% by weight.

3. The mixture according to claims 1-2, characterized in that the photosensitive diazonium salt has the following general formula:

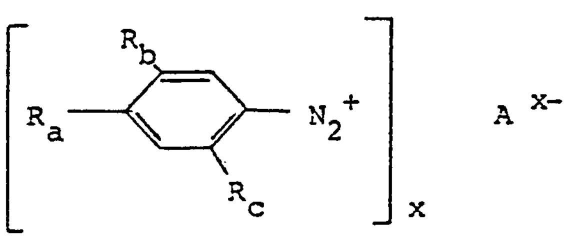

(I)

wherein:
$R_a$ is hydrogen, halogen, or an optionally substituted alkyl, alcoxy, aryloxy, arylamino, arylmercapto, benzoylamino group;
$R_b$ and/or $R_c$ are hydrogen or optionally substituted alkyl, alkylmercapto, alcoxy group, in which the alkyl residue is $C_1$-$C_3$, or aryloxy or arylmercapto groups;
A is $PF_6$, $BF_4$, $AsF_6$, $SbCl_6$, $SnCl_6$, $BiCl_5$, $ZnCl_4$, $SbF_6$, x being 1 or 2;
$R_a$ and $R_b$ cannot be hydrogen atoms at the same time.

4. The mixture according to claims 1-3, characterized in that hexafluorophosphate 2,5-diethoxy-4-(para-tolyl-mercapto)benzene-diazonium salt is used as the diazonium salt.

5. The mixture according to claims 1-3, characterized in that triphenylmethane dyes are used as basic dyes.

European Patent Office

# EUROPEAN SEARCH REPORT

Application Number

**EP 91 10 8925**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X,Y | DE-A-3 144 657 (KONISHIROKU PHOTO IND CO LTD)<br>* examples *<br>- - - | 1-3,5,4 | G 03 F 7/022 |
| X,Y | DE-A-3 144 656 (KONISHIROKU PHOTO IND CO LTD)<br>* claims 1-8 *<br>- - - | 1-3,5,4 | |
| D,Y | DE-A-2 641 099 (HOECHST AG)<br>* the whole document *<br>- - - - - | 4 | |
| | | | TECHNICAL FIELDS SEARCHED (Int. Cl.5) |
| | | | G 03 F |

The present search report has been drawn up for all claims

| Place of search | Date of completion of search | Examiner |
|---|---|---|
| The Hague | 24 September 91 | LUDI M.M.B. |

CATEGORY OF CITED DOCUMENTS

X: particularly relevant if taken alone
Y: particularly relevant if combined with another document of the same catagory
A: technological background
O: non-written disclosure
P: intermediate document
T: theory or principle underlying the invention

E: earlier patent document, but published on, or after the filing date
D: document cited in the application
L: document cited for other reasons

&: member of the same patent family, corresponding document